# EUROPEAN PATENT SPECIFICATION

(11) **EP 2 949 238 B1**
(45) Date of publication and mention of the grant of the patent: **06.07.2016**
(21) Application number: 14170151.6
(22) Date of filing: 28.05.2014
(51) Int. Cl.: A47B 88/04, H05K 7/14

(54) **BRACKET ASSEMBLY FOR SLIDE**
KLAMMERANORDNUNG FÜR SCHIENE
ENSEMBLE SUPPORT POUR GLISSIÈRE

(43) Date of publication of application: 02.12.2015
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Ho, Chun-Yi, Kaohsiung City (TW); Wang, Chun-Chiang, Kaohsiung City (TW)
(74) Representative: Viering, Jentschura & Partner mbB Patent- und Rechtsanwälte

(56) References cited:
- DE-U1-202009 011 027
- US-A1- 2012 292 274
- US-A1- 2013 112 638

## Description

### BACKGROUND OF THE INVENTION

### 1. Field of the Invention

The present invention relates to a bracket assembly for a slide which can be manually operated.

### 2. Description of the Related Art

In general, a rack device is assembled on a rack by means of a pair of slide assemblies. That is to say, the rack usually comprises a first pair of supports and a second pair of supports. Wherein, the first pair of supports corresponds in position to the second pair of supports. One side of the rack device is assembled on the first pair of supports by a slide assembly; the other side of the rack device is assembled on the second pair of supports by another slide assembly. Moreover, the supports of the rack each generally include at least one mounting hole; two opposite ends of each slide assembly respectively include a bracket. The bracket has an inserting member which can be inserted into the mounting holes of the supports, whereby the two opposite ends of each slide assembly can be respectively assembled on the supports of the rack for positioning the slide assembly on the rack.

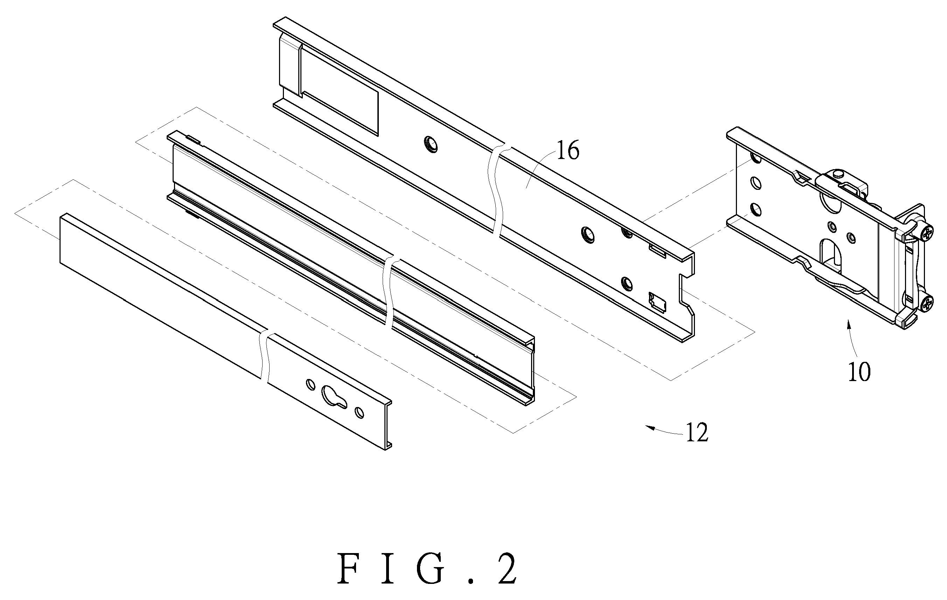

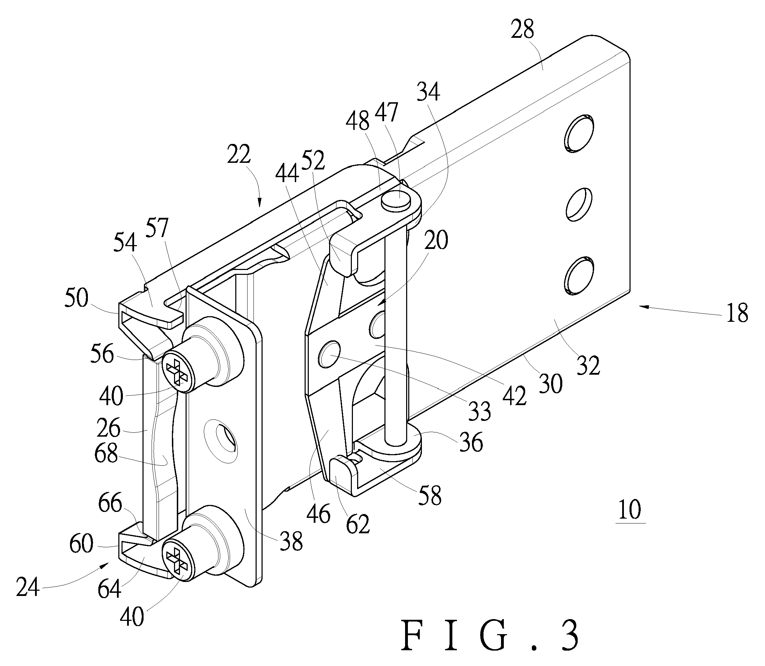

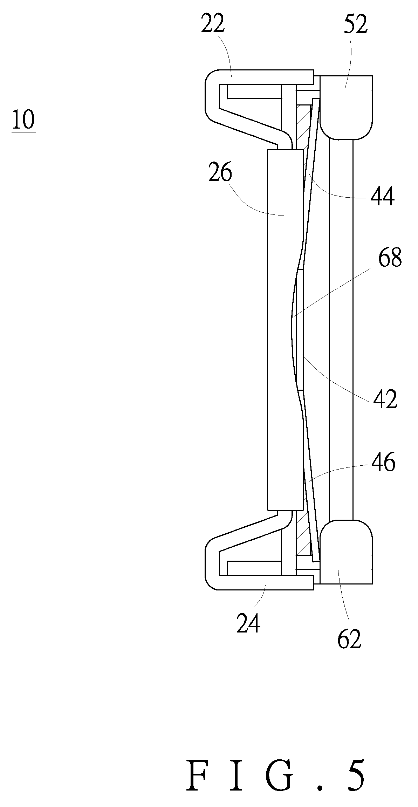

U.S. Patent No. 7,357,362 discloses a bracket positioning structure for a slide, in which, as shown in FIGS.2, 3, and 5, the bracket positioning structure for a slide is assembled on holes 71 of a support 7 via a pair of studs 2 formed on an end plate 11. Wherein, as shown in FIG.3, the studs 2 on the end plate 11 of the bracket 1 are respectively inserted into the holes 71 of the support 7 while the bracket positioning structure is assembled on the support 7. Moreover, a tooth 43 of an arm 42 of the bracket 1 is allowed to slide along an edge of the support 7 by means of a bevel edge 431 for shifting the arm 42. While the bracket 1 is moved to a position, as shown in FIG.5, the tooth 43 of the arm 42 of the bracket 1 will hooks the support 7 and is secured thereat, whereby the bracket 1 can be firmly positioned on the support 7. However, the bracket positioning structure does not have an operation member by which a user can control the movements of the arm 42 of the bracket 1. As a consequence, the convenience in assembling the bracket 1 on the support 7 and disassembling the bracket 1 from the support 7 is still wanted. US2013/0112638 A1 discloses the preamble of claim 1.

### SUMMARY OF THE INVENTION

The present invention relates to a manually-operable bracket assembly for a slide.

In one aspect of the present invention, a bracket assembly comprises a bracket, at least one inserting member, a first arm, and an elastic member. The bracket includes a longitudinal body and an end plate disposed on the longitudinal body. The inserting member is disposed on the end plate of the bracket. The first arm is movably connected to the bracket and has an end portion corresponding in position to the end plate of the bracket, wherein the end portion of the first arm is provided with a first hook portion. The elastic member is configured to urge the first hook portion of the first arm towards the bracket, wherein the bracket further includes a first connecting base and a second connecting base which are disposed on the longitudinal body of the bracket; the first arm is pivotally connected to the first connecting base; the bracket assembly further comprises a second arm pivotally connected to the second connecting base, characterised in that the elastic member is disposed on the bracket and located between the first connecting base and the second connecting base; the second arm has an end portion corresponding in position to the end plate of the bracket, wherein the end portion of the second arm is provided with a second hook portion; the elastic member is also configured to urge the second hook portion of the second arm towards the bracket.

Preferably, the elastic member further includes a base plate, a first elastic portion, and a second elastic portion, wherein at least one of the first elastic portion and the second elastic portion is uplifted from one end of the base plate.

Preferably, the bracket assembly further comprises an operation member connected between the first arm and the second arm.

Preferably, the bracket assembly is adapted to a rack which includes at least one hole, and the bracket assembly further comprises a second arm and an operation member. The elastic member is disposed on the bracket and includes a first elastic portion and a second elastic portion. The first arm includes a first portion and a second portion opposite to the first portion, wherein the first portion of the first arm includes a first contact portion abutting against the first elastic portion of the elastic member, and wherein the second portion of the first arm is the end portion corresponding in position to the end plate of the bracket and being provided with the first hook portion. The second arm is movably connected to the bracket and includes a first portion and a second portion opposite to the first portion, wherein the first portion of the second arm includes a second contact portion abutting against the second elastic portion of the elastic member, and wherein the second portion of the second arm corresponds in position to the end plate of the bracket and includes a second hook portion. The operation member is connected between the first arm and the second arm. When the bracket assembly is mounted on the rack, the at least one inserting member is inserted into the at least one hole of the rack, and meanwhile, the first hook portion of the second portion of the first arm and the second hook portion of the second portion of the second arm clasp the rack due to elastic force against the first contact portion and the second contact portion provided by the first elastic portion and the second elastic portion.

Preferably, the elastic member further includes a base plate, wherein the first elastic portion and the second elastic portion are uplifted from two opposite ends of the base plate, respectively.

Preferably, the bracket assembly further comprises a second arm and an operation member. The bracket further includes a first connecting base and a second connecting base corresponding in position to the first connecting base, wherein the first connecting base and the second connecting base are disposed on the longitudinal body. The elastic member is disposed on the bracket and located between the first connecting base and the second connecting base of the bracket and includes a first elastic portion and a second elastic portion. The first arm is pivotally connected to the first connecting base of the bracket and includes a first portion and a second portion opposite to the first portion, wherein the first portion of the first arm includes a first contact portion abutting against the first elastic portion of the elastic member, wherein the second portion of the first arm is the end portion corresponding in position to the end plate of the bracket and being provided with the first hook portion, and wherein the second portion of the first arm is further provided with a first connecting portion disposed close to the first hook portion. The second arm is pivotally connected to the second connecting base of the bracket and includes a first portion and a second portion opposite to the first portion, wherein the first portion of the second arm includes a second contact portion abutting against the second elastic portion of the elastic member, and wherein the second portion of the second arm corresponds in position to the end plate of the bracket and includes a second hook portion and a second connecting portion disposed close to the second hook portion. The operation member is connected between the first connecting portion of the first arm and the second connecting portion of the second arm.

Preferably, the elastic member further includes a base plate, wherein the first elastic portion and the second elastic portion are uplifted from two opposite ends of the base plate, respectively.

One characteristic of the embodiment of the present invention is that the bracket assembly is adapted to a slide assembly and can be assembled on a rack; moreover, when a user operates the operation member and does not release it until an inserting member of the bracket assembly is inserted into a hole of the rack, a hook portion of a arm can be driven to clasp the rack due to the elastic force provided by an elastic member, thus assembling the bracket assembly on the rack.

### BRIEF DESCRIPTION OF THE DRAWINGS

FIG.1 is a perspective view showing a bracket assembly which is disposed on a slide assembly and assembled on a rack;
FIG.2 is an exploded view of FIG.1 showing the bracket assembly which is disposed adjacent to one end of the slide assembly;
FIG.3 is a perspective view showing a bracket assembly in accordance with an embodiment of the present invention;
FIG.4 is an exploded view showing a bracket assembly in accordance with the embodiment of the present invention;
FIG.5 is schematic view showing a first contact portion and a second contact portion abut against a first elastic portion and a second elastic portion, respectively, while an operation member has not yet been operated;
FIG.6 is a schematic view showing a second portion of a first arm and a second portion of a second arm are moved away from an end plate of the bracket while the operation member is operated;
FIG.7 is a schematic view showing the first contact portion and the second contact portion press against the first elastic portion and the second elastic portion, respectively, while the operation member is operated;
FIG. 8 is a schematic view showing operations of assembling the bracket assembly on the rack;
FIG.9 is another schematic view showing operations of assembling the bracket assembly on the rack; and
FIG.10 is a perspective showing the bracket assembly positioned on the rack, wherein the first hook portion of the first arm and the second hook portion of the second arm clasp the rack.

### DETAILED DESCRIPTION OF THE PREFERRED EMBODIMENTS

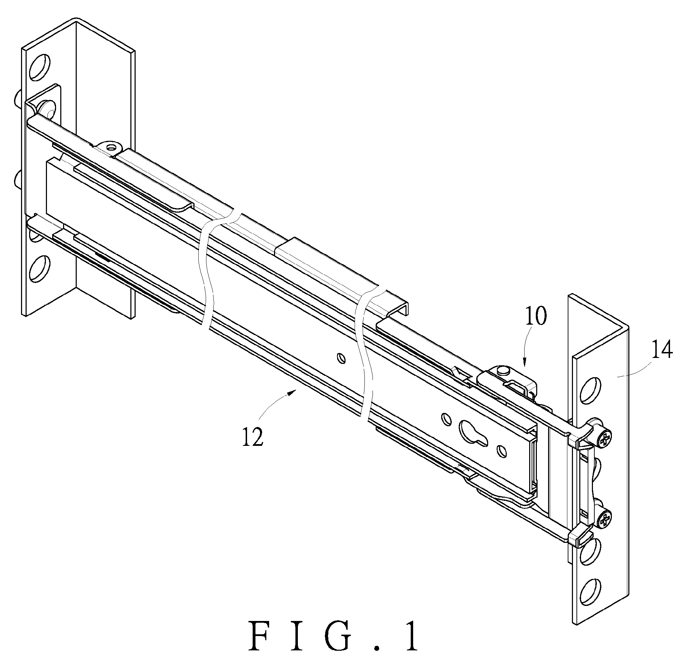

FIG.1 shows an embodiment of a bracket assembly **10** adapted to a slide assembly **12** and a rack **14,** wherein the slide assembly **12** can be mounted to the rack **14** by means of the bracket assembly **10.** As shown in FIG.2, the bracket assembly **10** can be disposed adjacent to an end of a first rail **16** (e.g., the outer rail) of the slide assembly **12.**

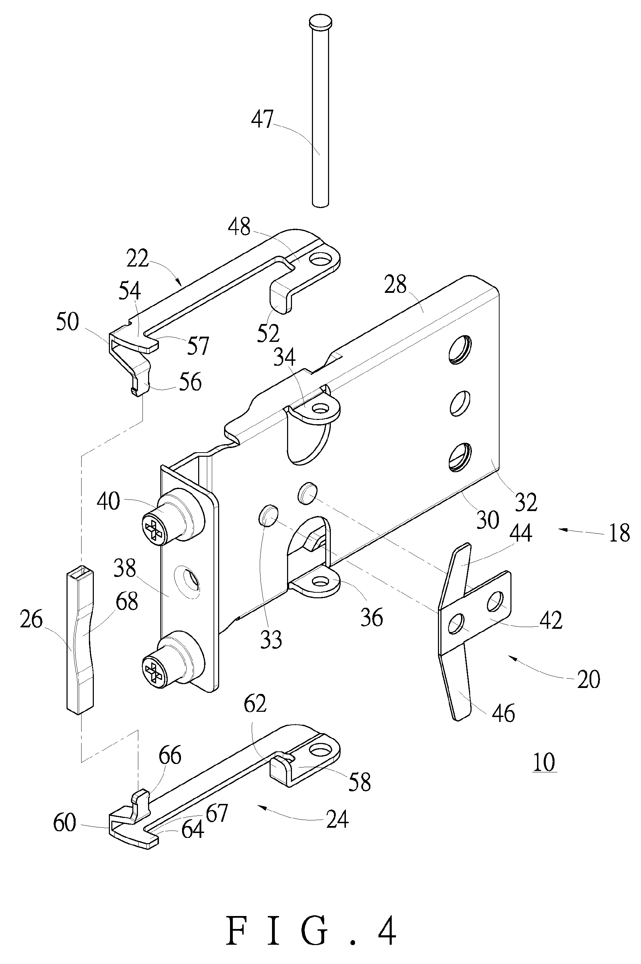

Referring to FIGS.3 to 5, the bracket assembly **10** comprises a bracket **18,** an elastic member **20,** a first arm **22,** a second arm **24,** and at least one inserting member **40.** The first arm **22** is provided with a first hook portion **54,** and the second arm **24** is provided with a second hook portion **64.**

The bracket **18** includes a first wall **28,** a second wall **30** disposed opposite to the first wall **28,** and a longitudinal body **32** connected between the first wall **28** and the second wall **30,** wherein the longitudinal body **32** includes at least one assembling portion **33.**

In more detail, the bracket **18** includes a first connecting base **34,** a second connecting base **36** corresponding in position to the first connecting base **34,** and an end plate **38** disposed on the longitudinal body **32.** Preferably, the end plate **38** is perpendicularly disposed adjacent to an end portion of the longitudinal body **32** of the bracket **18.** The first connecting base **34** and the second connecting base **36** are disposed on the longitudinal body **32** of the bracket **18,** wherein the first connecting base **34** is disposed adjacent to the first wall **28,** and the second connecting base **36** is disposed adjacent to the second wall **30.** The assembling portion **33** is preferably located between the first connecting base **34** and the second connecting base **36.**

The elastic member **20** is configured to urge at least one of the first hook portion **54** of the first arm **22** and the second hook portion **64** of the second arm **24** towards the bracket **18.** In one preferred embodiment, the elastic member **20** includes a base plate **42,** a first elastic portion **44,** and a second elastic portion **46.** The base plate **42** is correspondingly fit with the assembling portion **33** of the longitudinal body **32** of the bracket **18** so that the elastic member **20** can be disposed on the longitudinal body **32** of the bracket **18** and located between the first connecting base **34** and the second connecting base **36.** The first elastic portion **44** and the second elastic portion **46** are uplifted from two opposite ends of the base plate **42,** respectively. Accordingly, a predetermined included angle is formed between the first elastic portion **44** and the longitudinal body **32** of the bracket **18** for allowing the first elastic portion **44** to be pressed down elastically and thereby generate a first elastic force; also, a predetermined included angle is formed between the second elastic portion **46** and the longitudinal body **32** of the bracket **18** for allowing the second elastic portion **46** to be pressed down elastically and thereby generate a second elastic force.

The first arm **22** is movably connected to the bracket **18.** Preferably, the first arm **22** is pivotally connected to the first connecting base **34** of the bracket **18** via a connecting element **47** and is rotatable in response to the first elastic force of the first elastic portion **44** of the elastic member **20.** Further, the first arm **22** includes a first portion **48** and a second portion **50** opposite to the first portion **48.** The first portion **48** of the first arm **22** includes a first contact portion **52** correspondingly abutting against the first elastic portion **44** of the elastic member **20,** wherein the first contact portion **52** can be bent to form an L-shape, but is not limited thereto. The second portion **50** of the first arm **22** corresponds in position to the end plate **38** of the bracket **18** and includes a first connecting portion **56,** wherein the first hook portion **54** is also disposed on the second portion **50** of the first arm **22** and located close to the first connecting portion **56.** The first hook portion **54** of the first arm **22** includes a hook surface **57** and extends in a horizontal direction, while the first connecting portion **56** extends in a vertical direction. It is noted that the second portion **50** of the first arm **22** can be moved toward and away from the end plate **38** of the bracket **18** in response to rotation of the first arm **22.**

The second arm **24** is movably connected to the bracket **18.** Preferably, the second arm **24** is pivotally connected to the second connecting base **36** of the bracket **18** via the connecting element **47** and is rotatable in response to the second elastic force of the second elastic portion **46** of the elastic member **20.** The second arm **24** includes a first portion **58** and a second portion **60** opposite to the first portion **58.** The first portion **58** of the second arm **24** includes a second contact portion **62** correspondingly abutting against the second elastic portion **46** of the elastic member **20,** wherein the second contact portion **62** is bent to form an L-shape, but is not limited thereto. The second portion **60** of the second arm **24** corresponds in position to the end plate **38** of the bracket **18** and includes a second connecting portion **66,** wherein the second hook portion **64** is also disposed on the second portion **60** of the second arm **24** and located close to the second connecting portion **66.** The second hook portion **64** of the second arm **24** includes a hook surface **67** and extends in a horizontal direction, while the second connecting portion **66** extends in a vertical direction. It is noted that the second portion **60** of the second arm **24** can be moved toward and away from the end plate **38** of the bracket **18** in response to rotation of the second arm **24.**

The inserting member **40** is disposed on the end plate **38** of the bracket **18,** wherein the inserting member **40** can be a circular stud, a square stud, or stud formed in other shapes. In other words, the inserting member **40** is not restricted to be formed as the circular stud illustrated in this embodiment.

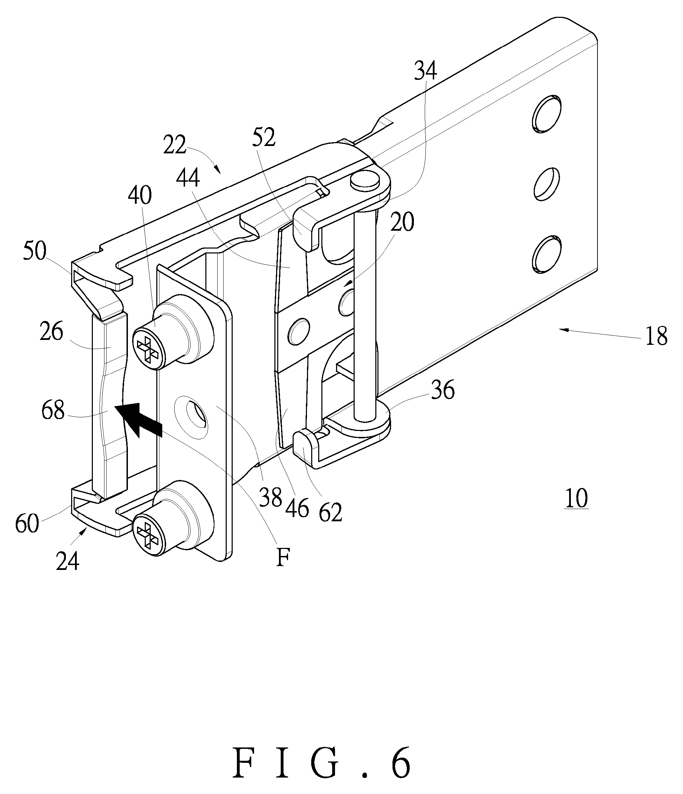

Preferably, the bracket assembly **10** further comprises an operation member **26.** The operation member **26** is assembled to or integrally formed with the first connecting portion **56** of the first arm **22** and the second connecting portion **66** of the second arm **24** and thus extends between the first connecting portion **56** of the first arm **22** and the second connecting portion **66** of the second arm **24.** The operation member **26** can be formed into a rod-like shank with a slightly curved operating surface **68,** whereby user can simply operate the operation member **26** by fingers to rotate the first arm **22** and the second arm **24,** for example, from a first position (as shown in FIG.3) to a second position (as shown in FIG.6).

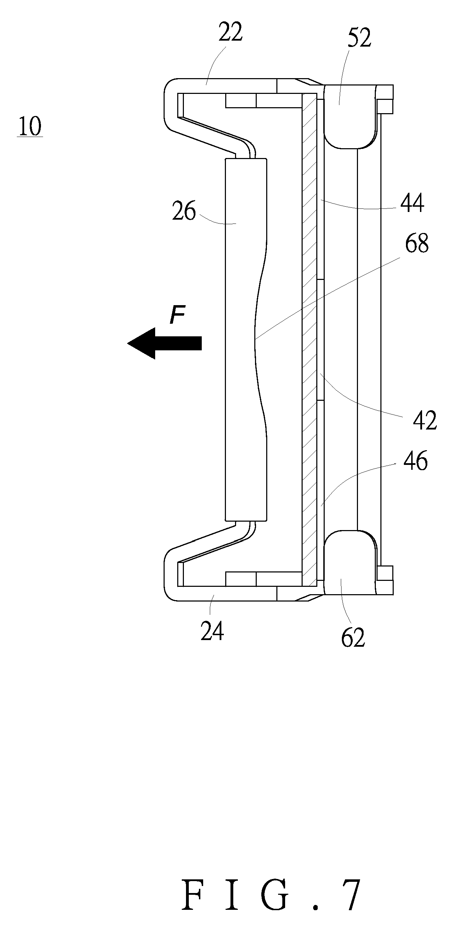

Referring to FIGS.6 and 7, when a user exerts a force **F** on the operating surface **68** of the operation member **26,** the first arm **22** and the second arm **24** are driven to rotate from the first position (as shown in FIGS.3 and 5) to the second position (as shown in FIGS. 6 and 7) and make the second portion **50** of the first arm **22** and the second portion **60** of the second arm **24** be moved away from the end plate **38** of the bracket **18** due to the fact that the first arm **22** and the second arm **24** are pivotally connected to the first connecting base **34** and the second connecting base **36,** respectively; meanwhile, the first elastic portion **44** is pressed against by the first contact portion **52** of the first arm **22** to accumulate the first elastic force, and the second elastic portion **46** of the elastic member **20** is pressed against by the second contact portion **62** of the second arm **24** to accumulate the second elastic force.

Further, when the operation member **26** is not operated any more (i.e., when the force **F** is removed from the operating surface **68** of the operation member **26**), the accumulated first elastic force and second elastic force are released to allow the first elastic portion **44** and the second elastic portion **46** to push against the first contact portion **52** of the first arm **22** and the second contact portion **62** of the second arm **24,** respectively. Therefore, the first arm **22** and the second arm **24** are rotated back and drive the second portion **50** of the first arm **22** and the second portion **60** of the second arm **24** to move toward the end plate **38** of the bracket **18.** Namely, the first arm **22** and the second arm **24** are rotated back from the second position (as shown in FIGS.6 and 7) to the first position (as shown in FIGS. 3 and 5). Simultaneously, the first elastic portion **44** and the second elastic portion **46** of the elastic member **20** return to their respect original states, i.e., uplifted from two opposite ends of the base plate **42** respectively.

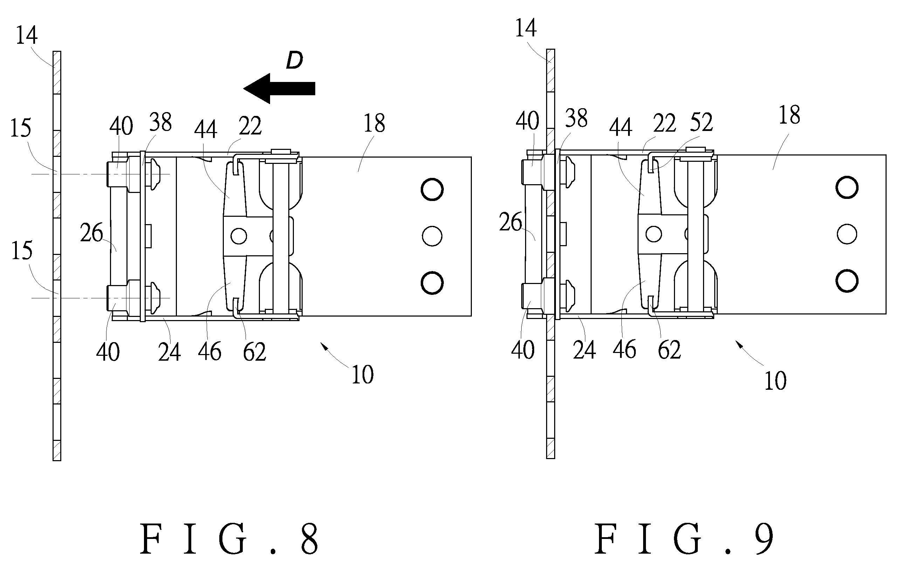

FIGS. 8 and 9 are schematic views showing how the bracket assembly **10** is assembled on the rack **14.**

Specifically, the bracket assembly **10** is adapted to the rack **14** which includes at least one hole **15,** wherein the hole **15** can be formed in a circle, square, or other shapes. That is to say that the hole **15** is not restricted to be formed in a circle as shown in this embodiment.

To assemble the bracket **18** on the rack **14,** the user initially operates the operation member **26** (as shown in FIG. 6) to move the second portion **50** of the first arm **22** and the second portion **60** of the second arm **24** away from the end plate **38** of the bracket **18,** and simultaneously, the user moves the bracket assembly **10** toward the rack **14** in a direction **D** for allowing the inserting member **40** to be aligned with and received in the hole **15** of the rack **14.** Consequently, the second portion **50** of the first arm **22** and the second portion **60** of the second arm **24** are spaced apart from the rack **14** by a distance during the insertion of the inserting member **40** into the hole **15** of the rack **14.**

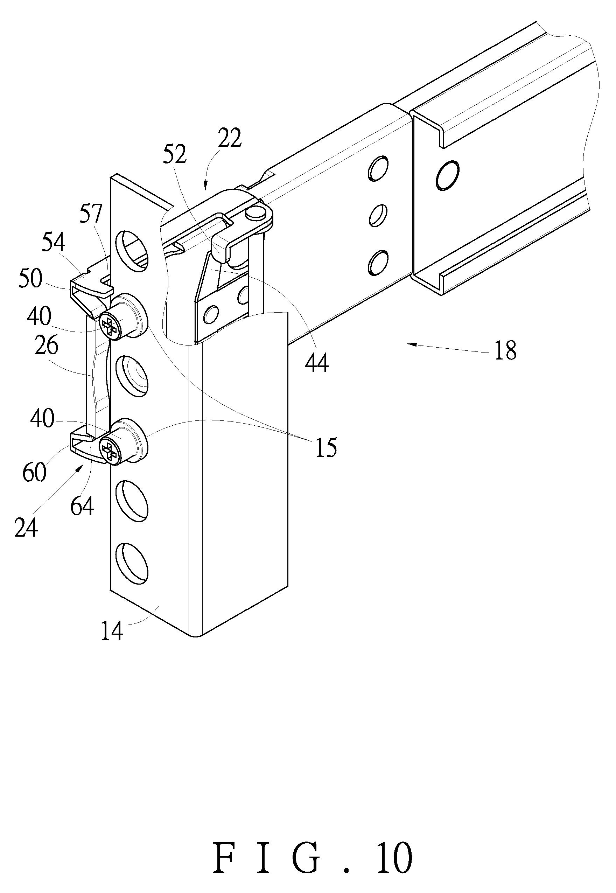

Subsequently, referring to FIG.10, the user stops operating the operation member **26** (i.e., releases the operation member **26**) after the inserting member **40** is inserted into the hole **15** of the rack **14.** As a result, the first elastic portion **44** and the second elastic portion **46** return to their respect original states (as shown in FIG.3) due to their elasticity, and thus the first contact portion **52** and the second contact portion **62** are pushed against by the first elastic portion **44** and the second elastic portion **46,** respectively, and thereby drive the first hook portion **54** of the second portion **50** of the first arm **22** and the second hook portion **64** of the second portion **60** of the second arm **24** to clasp the rack **14** by means of the hook surface **57** of the first hook portion **54** and the hook surface **67** of the second hook portion **64.** Therefore, the bracket **18** is firmly assembled on the rack **14.**

## Claims

1. A bracket assembly (10) for a slide, comprising:
a bracket (18) including a longitudinal body (32) and an end plate (38) disposed on the longitudinal body (32);
at least one inserting member (40) disposed on the end plate (38) of the bracket (18);
a first arm (22) movably connected to the bracket (18), the first arm (22) having an end portion corresponding in position to the end plate (38) of the bracket (18), the end portion of the first arm (22) being provided with a first hook portion (54); and
an elastic member (20) configured to urge the first hook portion (54) of the first arm (22) towards the bracket (18), wherein the bracket (18) further includes a first connecting base (34) and a second connecting base (36) which are disposed on the longitudinal body (32) of the bracket (18), wherein the first arm (22) is pivotally connected to the first connecting base (34), and wherein the bracket assembly (10) further comprises a second arm (24) pivotally connected to the second connecting base (36), **characterised in that**
the elastic member (20) is disposed on the bracket (18) and located between the first connecting base (34) and the second connecting base (36), wherein the second arm (24) has an end portion corresponding in position to the end plate (38) of the bracket (18), wherein the end portion of the second arm (24) is provided with a second hook portion (64), and wherein the elastic member (20) is also configured to urge the second hook portion (64) of the second arm (24) towards the bracket (18).

2. The bracket assembly (10) as claimed in claim 1, wherein the elastic member (20) further includes a base plate (42), a first elastic portion (44), and a second elastic portion (46), and wherein at least one of the first elastic portion (44) and the second elastic portion (46) is uplifted from one end of the base plate (42).

3. The bracket assembly (10) as claimed in claim 1, further comprising an operation member (26) connected between the first arm (22) and the second arm (24).

4. The bracket assembly (10) as claimed in claim 1, wherein the bracket assembly (10) is adapted to a rack (14) which includes at least one hole (15), and the bracket assembly (10) further comprises an operation member (26) connected between the first arm (22) and the second arm (24);
wherein the elastic member (20) includes a first elastic portion (44) and a second elastic portion (46);
wherein the first arm (22) includes a first portion (48) and a second portion (50) opposite to the first portion (48), wherein the first portion (48) of the first arm (22) includes a first contact portion (52) abutting against the first elastic portion (44) of the elastic member (20), and wherein the second portion (50) of the first arm (22) is the end portion corresponding in position to the end plate (38) of the bracket (18) and being provided with the first hook portion (54);
wherein the second arm (24) includes a first portion (58) and a second portion (60) opposite to the first portion (58), wherein the first portion (58) of the second arm (24) includes a second contact portion (62) abutting against the second elastic portion (46) of the elastic member (20), and wherein the second portion (60) of the second arm (24) is the end portion corresponding in position to the end plate (38) of the bracket (18) and being provided with the second hook portion (64); and
wherein, when the bracket assembly (10) is mounted on the rack (14), the at least one inserting member (40) is inserted into the at least one hole (15) of the rack (14), and meanwhile, the first hook portion (54) of the second portion (50) of the first arm (22) and the second hook portion (64) of the second portion (60) of the second arm (24) clasp the rack (14) due to elastic force against the first contact portion (52) and the second contact portion (62) provided by the first elastic portion (44) and the second elastic portion (46).

5. The bracket assembly (10) as claimed in claim 4 , wherein the elastic member (20) further includes a base plate (42), and the first elastic portion (44) and the second elastic portion (46) are uplifted from two opposite ends of the base plate (42), respectively.

6. The bracket assembly (10) as claimed in claim 1, further comprising an operation member (26);
wherein the elastic member (20) includes a first elastic portion (44) and a second elastic portion (46);
wherein the first arm (22) includes a first portion (48) and a second portion (50) opposite to the first portion (48), wherein the first portion (48) of the first arm (22) includes a first contact portion (52) abutting against the first elastic portion (44) of the elastic member (20), wherein the second portion (50) of the first arm (22) is the end portion corresponding in position to the end plate (38) of the bracket (18) and being provided with the first hook portion (54), and wherein the second portion (50) of the first arm (22) is further provided with a first connecting portion (56) disposed close to the first hook portion (54);
wherein the second arm (24) includes a first portion (58) and a second portion (60) opposite to the first portion (58), wherein the first portion (58) of the second arm (24) includes a second contact portion (62) abutting against the second elastic portion (46) of the elastic member (20), wherein the second portion (60) of the second arm (24) is the end portion corresponding in position to the end plate (38) of the bracket (18) and being provided with the second hook portion (64), and wherein the second portion (60) of the second arm (24) is further provided with a second connecting portion (66) disposed close to the second hook portion (64); and
wherein the operation member (26) is connected between the first connecting portion (56) of the first arm (22) and the second connecting portion (66) of the second arm (24).

7. The bracket assembly (10) as claimed in claim 6, wherein the elastic member (20) further includes a base plate (42), and wherein the first elastic portion (44) and the second elastic portion (46) are uplifted from two opposite ends of the base plate (42), respectively.

## Patentansprüche

1. Eine Halterungseinheit (10) für einen gleitbaren Aufbau, umfassend:
einer Halterung (18) mit einem Längskörper (32) und einer Endplatte (38), die am Längskörper (32) angeordnet ist;
mindestens einem Einsetzteil (40), das an der Endplatte (38) der Halterung (18) vorgesehen ist;
einem ersten Ausleger (22), der beweglich an der Halterung (18) befestigt ist; der erste Ausleger (22) einen Abschlussteil aufweist, der übereinstimmend mit der Endplatte (38) der Halterung (18) angeordnet ist; der Abschlussteil des ersten Auslegers (22) mit einem ersten Haken (54) gebildet ist; und
einem elastischen Glied (20), das zum Anschieben des ersten Hakens (54) am ersten Ausleger (22) auf die Halterung (18) zu konfiguriert ist, wobei die Halterung (18) weiter aus einem ersten Anschlusssockel (34) und aus einem zweiten Anschlusssockel (36) besteht, die am Längskörper (32) der Halterung (18) angeordnet sind; der erste Ausleger (22) drehgelenkig am ersten Anschlusssockel (34) befestigt ist und die Halterungseinheit (10) weiter einen zweiten Ausleger (24) aufweist, der drehgelenkig am zweiten Anschlusssockel (36) befestigt ist, **dadurch gekennzeichnet, dass** das elastische Glied (20) an der Halterung (18) und zwischen dem ersten Anschlusssockel (34) und dem zweiten Anschlusssockel (36) angeordnet ist; der zweite Ausleger (24) einen Abschlussteil aufweist, der übereinstimmend mit der Endplatte (38) der Halterung (18) positioniert ist; das Abschlussteil am zweiten Ausleger (24) mit einem zweiten Haken (64) gebildet ist, wobei das elastische Glied (20) ebenfalls zum Anschieben des zweiten Hakens (64) am zweiten Ausleger (24) auf die Halterung (18) zu konfiguriert ist.

2. Die Halterungseinheit (10) nach Anspruch 1, wobei das elastische Glied (20) weiter aus einer Grundplatte (42), einem ersten elastischen Teil (44) und aus einem zweiten elastischen Teil (46) besteht und wobei mindestens einer der ersten elastischen Teile (44) und einer der zweiten elastischen Teile (46) von einem Ende der Grundplatte (42) erhoben wird.

3. Die Halterungseinheit (10) nach Anspruch 1, weiter bestehend aus einem Betätigungsglied (26), das zwischen dem ersten Ausleger (22) und dem zweiten Ausleger (24) befestigt ist.

4. Die Halterungseinheit (10) nach Anspruch 1, wobei die Halterungseinheit (10) an einem Gestell (14) montiert ist, das mindestens ein Loch (15) aufweist, während die Halterungseinheit (10) weiter aus einem Betätigungsglied (26) besteht, das zwischen dem ersten Ausleger (22) und dem zweiten Ausleger (24) befestigt ist;
wobei das elastische Glied (20) aus einem ersten elastischen Teil (44) und aus einem zweiten elastischen Teil (46) besteht;
wobei der erste Ausleger (22) aus einem ersten Teil (48) und aus einem zweiten Teil (50) gegenüber dem ersten Teil (48) besteht; der erste Teil (48) des ersten Auslegers (22) mit einem ersten Kontaktteil (52) gebildet ist, der an den ersten elastischen Teil (44) am elastischen Glied (20) anstößt und wobei der zweite Teil (50) des ersten Auslegers (22) der Abschlussteil ist, der übereinstimmend mit der Endplatte (38) der Halterung (18) positioniert und mit dem ersten Haken (54) gebildet ist;
wobei der zweite Ausleger (24) aus einem ersten Teil (58) und aus einem zweiten Teil (60) gegenüber dem ersten Teil (58) besteht, wobei der erste Teil (58) des zweiten Auslegers (24) mit einem zweiten Kontaktteil (62) gebildet ist, der an den zweiten elastischen Teil (46) am elastischen Glied (20) anstößt und wobei der zweite Teil (60) des zweiten Auslegers (24) der Abschlussteil ist, der übereinstimmend mit der Endplatte (38) der Halterung (18) positioniert und mit dem zweiten Haken (64) gebildet ist; und
wobei beim Montieren der Halterungseinheit (10) an das Gestell (14) das mindestens eine Einsetzteil (40) in das mindestens eine Loch (15) im Gestell (14) eingesetzt wird und der erste Haken (54) des zweiten Teils (50) am ersten Ausleger (22) sowie der zweite Haken (64) des zweiten Teils (60) am zweiten Ausleger (24) das Gestell (14) wegen der Spannkraft, die vom ersten elastischen Teil (44) und vom zweiten elastischen Teil (46) gegen den ersten Kontaktteil (52) und den zweiten Kontaktteil (62) ausgeübt wird, gleichzeitig umklammern.

5. Die Halterungseinheit (10) nach Anspruch 4, wobei das elastische Glied (20) weiter aus einer Grundplatte (42) besteht und der erste elastische Teil (44) sowie der zweite elastische Teil (46) je von einem der beiden gegenüber gebildeten Enden der Grundplatte (42) erhoben werden.

6. Die Halterungseinheit (10) nach Anspruch 1, weiter umfassend einem Betätigungsglied (26);
wobei das elastische Glied (20) aus einem ersten elastischen Teil (44) und aus einem zweiten Teil (46) besteht;
wobei der erste Ausleger (22) aus einem ersten Teil (48) und aus einem zweiten Teil (50) gegenüber dem ersten Teil (48) besteht; der erste Teil (48) am ersten Ausleger (22) einen ersten Kontaktteil (52) aufweist, der an den ersten elastischen Teil (44) des elastischen Gliedes (20) anstößt; der zweite Teil (50) am ersten Ausleger (22) der Abschlussteil ist, der übereinstimmend mit der Endplatte (38) der Halterung (18) positioniert und mit dem ersten Haken (54) gebildet ist; der zweite Teil (50) am ersten Ausleger (22) weiter einen ersten Verbindungsteil (56) aufweist, der nahe zum ersten Haken (54) angeordnet ist;
wobei der zweite Ausleger (24) aus einem ersten Teil (58) und aus einem zweiten Teil (60) gegenüber dem ersten Teil (58) besteht; der erste Teil (58) am zweiten Ausleger (24) einen zweiten Kontaktteil (62) aufweist, der an den zweiten elastischen Teil (46) des elastischen Gliedes (20) anstößt; der zweite Teil (60) am zweiten Ausleger (24) der Abschlussteil ist, der übereinstimmend mit der Endplatte (38) der Halterung (18) positioniert und mit dem zweiten Haken (64) gebildet ist; der zweite Teil (60) am zweiten Ausleger (24) weiter einen zweiten Verbindungsteil (66) aufweist, der nahe zum zweiten Haken (64) angeordnet ist; und
wobei das Betätigungsglied (26) zwischen dem ersten Verbindungsteil (56) am ersten Ausleger (22) und dem zweiten Verbindungsteil (66) am zweiten Ausleger (24) befestigt ist.

7. Die Halterungseinheit (10) nach Anspruch 6, wobei das elastische Glied (20) weiter aus einer Grundplatte (42) besteht und der erste elastische Teil (44) sowie der zweite elastische Teil (46) je von einem der beiden gegenüber gebildeten Enden der Grundplatte (42) erhoben werden.

## Revendications

1. Un assemblage de support (10) pour une glissière, comprenant :
un support (18) comportant un corps longitudinal (32) et une plaque d'extrémité (38) disposée sur le corps longitudinal (32) ;
au moins un élément d'insertion (40) disposé sur la plaque d'extrémité (38) du support (18) ;
un premier bras (22) relié de façon mobile au support (18), le premier bras (22) présentant une partie d'extrémité correspondant en position à la plaque d'extrémité (38) du support (18), la partie d'extrémité du premier bras (22) étant pourvue d'une première partie en forme de crochet (54) ; et
un élément élastique (20) configuré pour pousser la première partie en forme de crochet (54) du premier bras (22) vers le support (18), dans lequel le support (18) comporte en outre une première base de liaison (34) et une seconde base de liaison (36) qui sont disposées sur le corps longitudinal (32) du support (18), dans lequel le premier bras (22) est relié de façon pivotante à la première base de liaison (34), et dans lequel l'assemblage de support (10) comprend en outre un second bras (24) relié de façon pivotante à la seconde base de liaison (36), **caractérisé en ce que** l'élément élastique (20) est disposé sur le support (18) et situé entre la première base de liaison (34) et la seconde base de liaison (36), dans lequel le second bras (24) présente une partie d'extrémité correspondant en position à la plaque d'extrémité (38) du support (18), dans lequel la partie d'extrémité du second bras (24) est pourvue d'une seconde partie en forme de crochet (64), et dans lequel l'élément élastique (20) est également configuré pour pousser la seconde partie en forme de crochet (64) du second bras (24) vers le support (18).

2. L'assemblage de support (10) selon la revendication 1, dans lequel l'élément élastique (20) comporte en outre une plaque de soutien (42), une première partie élastique (44), et une seconde partie élastique (46), et dans lequel au moins la première partie élastique (44) ou la seconde partie élastique (46) est soulevée à partir d'une extrémité de la plaque de soutien (42).

3. L'assemblage de support (10) selon la revendication 1, comprenant en outre un élément fonctionnel (26) relié entre le premier bras (22) et le second bras (24).

4. L'assemblage de support (10) selon la revendication 1, dans lequel l'assemblage de support (10) est adapté à un châssis (14) qui comporte au moins un trou (15), et l'assemblage de support (10) comprend en outre un élément fonctionnel (26) relié entre le premier bras (22) et le second bras (24) ;
dans lequel l'élément élastique (20) comporte une première partie élastique (44) et une seconde partie élastique (46) ;
dans lequel le premier bras (22) comporte une première partie (48) et une seconde partie (50) opposée à la première partie (48), dans lequel la première partie (48) du premier bras (22) comporte une première partie de contact (52) en butée contre la première partie élastique (44) de l'élément élastique (20), et dans lequel la seconde partie (50) du premier bras (22) est la partie d'extrémité correspondant en position à la plaque d'extrémité (38) du support (18) et étant pourvue de la première partie en forme de crochet (54) ;
dans lequel le second bras (24) comporte une première partie (58) et une seconde partie (60) opposée à la première partie (58), dans lequel la première partie (58) du second bras (24) comporte une seconde partie de contact (62) en butée contre la seconde partie élastique (46) de l'élément élastique (20), et dans lequel la seconde partie (60) du second bras (24) est la partie d'extrémité correspondant en position à la plaque d'extrémité (38) du support (18) et étant pourvue de la seconde partie en forme de crochet (64) ; et
dans lequel, quand l'assemblage de support (10) est monté sur le châssis (14), le ou les éléments d'insertion (40) est inséré dans le ou les trous (15) du châssis (14), et pendant ce temps, la première partie en forme de crochet (54) de la seconde partie (50) du premier bras (22) et la seconde partie en forme de crochet (64) de la seconde partie (60) du second bras (24) serrent le châssis (14) du fait de la force élastique contre la première partie de contact (52) et la seconde partie de contact (62) fournie par la première partie élastique (44) et la seconde partie élastique (46).

5. L'assemblage de support (10) selon la revendication 4, dans lequel l'élément élastique (20) comporte en outre une plaque de soutien (42), et la première partie élastique (44) et la seconde partie élastique (46) sont soulevées à partir de deux extrémité opposées de la plaque de soutien (42), respectivement.

6. L'assemblage de support (10) selon la revendication 1, comprenant en outre un élément fonctionnel (26) ;
dans lequel l'élément élastique (20) comporte une première partie élastique (44) et une seconde partie élastique (46) ;
dans lequel le premier bras (22) comporte une première partie (48) et une seconde partie (50) opposée à la première partie (48), dans lequel la première partie (48) du premier bras (22) comporte une première partie de contact (52) en butée contre la première partie élastique (44) de l'élément élastique (20), dans lequel la seconde partie (50) du premier bras (22) est la partie d'extrémité correspondant en position à la plaque d'extrémité (38) du support (18) et étant pourvue de la première partie en forme de crochet (54), et dans lequel la seconde partie (50) du premier bras (22) est en outre munie d'une première partie de liaison (56) disposée près de la première partie en forme de crochet (54) ;
dans lequel le second bras (24) comporte une première partie (58) et une seconde partie (60) opposée à la première partie (58), dans lequel la première partie (58) du second bras (24) comporte une seconde partie de contact (62) en butée contre la seconde partie élastique (46) de l'élément élastique (20), dans lequel la seconde partie (60) du second bras (24) est la partie d'extrémité correspondant en position à la plaque d'extrémité (38) du support (18) et étant pourvue de la seconde partie en forme de crochet (64), et dans lequel la seconde partie (60) du second bras (24) est en outre munie d'une seconde partie de liaison (66) disposée près de la seconde partie en forme de crochet (64) ; et
dans lequel l'élément fonctionnel (26) est relié entre la première partie de liaison (56) du premier bras (22) et la seconde partie de liaison (66) du second bras (24).

7. L'assemblage de support (10) selon la revendication 6, dans lequel l'élément élastique (20) comporte en outre une plaque de soutien (42), et dans lequel la première partie élastique (44) et la seconde partie élastique (46) sont soulevées à partir de deux extrémité opposées de la plaque de soutien (42), respectivement.
